# EUROPÄISCHE PATENTSCHRIFT

(11) **EP 1 905 071 B1**
(45) Veröffentlichungstag und Bekanntmachung des Hinweises auf die Patenterteilung: **13.04.2011**
(21) Anmeldenummer: 07723509.1
(22) Anmeldetag: 22.03.2007
(51) Int. Cl.: H01L 21/683

(54) **VERFAHREN UND VORRICHTUNG ZUR ELEKTROSTATISCHEN FIXIERUNG VON SUBSTRATEN MIT POLARISIERBAREN MOLEKÜLEN**
METHOD AND APPARATUS FOR ELECTROSTATIC FIXING OF SUBSTRATES WITH MOLECULES WHICH CAN BE POLARIZED
PROCÉDÉ ET DISPOSITIF DE FIXATION ÉLECTROSTATIQUE DE SUBSTRATS AVEC DES MOLÉCULES POLARISABLES

(30) Priorität: 23.03.2006 DE 102006013517
(43) Veröffentlichungstag der Anmeldung: 02.04.2008
(73) Patentinhaber: Fraunhofer-Gesellschaft zur Förderung der angewandten Forschung e.V., 80686 München (DE)
(72) Erfinder: LANDESBERGER, Christof, 82166 Gräfelfing (DE)
(74) Vertreter: Stöckeler, Ferdinand
(86) Internationale Anmeldenummer: PCT/EP2007/002555
(87) Internationale Veröffentlichungsnummer: WO 2007/110192

(56) Entgegenhaltungen:
- WO-A-02/11184
- DE-B3- 10 235 814
- JP-A- 2006 149 156
- US-A- 4 016 456

## Beschreibung

Die vorliegende Erfindung bezieht sich auf eine Fixierung von Substraten auf Trägersystemen durch elektrostatische Anziehung.

Die Herstellung von elektronischen Systemen auf flexiblen Substraten, wie beispielsweise Folien aus Kunststoff, Papier oder Metall, gewinnt zunehmend an Bedeutung. Als zukünftige Anwendungen seien hier genannt: flexible Displays, flexible Solarzellen, flexible Leuchtflächen und allgemein elektrische Schaltungen, die aufgrund der Flexibilität des Substrats sich leicht verformen lassen und somit vorgegebene Gehäusevolumen optimal platzsparend ausfüllen können.

Ein aktueller Entwicklungsschwerpunkt auf dem Gebiet der flexiblen Elektronik sind gedruckte Schaltungen auf der Basis von organischen Materialien, wie beispielsweise halbleitende Polymere, polymere Leiterbahnmaterialien, polymere Dielektrikas u.a.. Gerade die Drucktechnik bietet sich als eine sehr kostengünstige Verfahrenstechnik an. In Verbindung mit flexiblen Substraten können hierfür durchlaufende Rolle-zu-Rolle Produktionstechniken genutzt werden. Während der Entwicklungsphase von neuen Verfahren und Materialien für flexible Elektroniken sind durchlaufende Rolle-zu-Rolle-Prozesse allerdings zu aufwändig. Hier wäre es vorteilhaft, die flexiblen Substrate auch als Einzelblattbögen ("sheets") in Anlagen und Prozesssystemen bearbeiten zu können. Dies würde auch die Möglichkeit eröffnen, bereits vorhandene Produktionsanlagen auch für flexible Substrate nutzen zu können.

Die Handhabung einzelner, flexibler Substrate ist jedoch schwierig. Für Beschichtungsprozesse mit flüssigen Medien, Trocknungsvorgänge im Ofen oder bei lithografischer Strukturierung müssen die Folien flach auf einer Unterlage fixiert sein und sollen außerdem mit automatischen Handhabungssystemen verarbeitet werden können.

Einzelne flexible Folien können in Beschichtungsanlagen verarbeitet werden, wenn sie auf starre Substrate montiert werden. Eine einfache Variante hierfür ist das Ankleben der Ecken eines Folienbogens auf einer etwas größer dimensionierten, starren Trägerplatte mittels Klebeband. Dies ist aber mit erheblichem manuellen Aufwand verbunden. Auch ist das Abziehen der Klebebänder nach Temperaturschritten oft schwierig bzw. mit erheblichen Rückständen verbunden. Im Falle von Trocknungsprozessen auf Heizplatten ("hotplates") ist zudem kein gleichmäßiger, flächiger Wärmekontakt gegeben; Luftblasen und Aufwölbungen der Folien verhindern eine wirklich flache Auflage des Substratbogens. Ungleichmäßiger Wärmekontakt und gewellte Form des Substrats führen unweigerlich zu ungleichmäßigen Schichtdicken, was im Falle von leitenden oder halbleitenden Schichten zu stark variierenden und somit unbrauchbaren elektronischen Eigenschaften führt.

Eine vollflächige Verklebung von Folie mit Trägersubstrat ist grundsätzlich möglich; dann aber mit noch größerem Bearbeitungsaufwand verbunden. Wiederlösbare Klebetechniken stellen deshalb keine kostengünstige und praktikable Lösungen dar. Alternativ könnten die Folien auf perforierten Vakuumsaugplatten fixiert werden. Dann allerdings ist das automatische Beladen und Entladen der gewellten Folien weiterhin nicht sinnvoll gelöst.

Bekannt sind auch elektrostatische Haltetechniken für dünne Substrate, wobei man unipolare und bipolare Halterungen bzw. Träger unterscheidet. Im Fall des unipolaren Trägers weist die Trägerplatte nur eine Flächenelektrode auf und trägt dementsprechend nur Ladungen einer Polarität (unipolar). Bei einem bipolaren Träger wird eine Trägerplatte genutzt, die mindestens zwei elektrisch getrennte Flächenelektroden aufweist, die mit entgegengesetzter Polarität aufgeladen werden. Eine Vorrichtung für einen unipolaren Träger ist in JP 59132139 beschrieben und ein entsprechendes Verfahren zur Halterung ist in der DE 10235814 B3 angegeben. Diese Halterung ist für elektrisch leitende Substrate geeignet, wobei zwischen dem Substrat und der Trägerplatte eine Schicht mit hoher Dielektrizitätskonstante gebracht wird, so dass die Fixierung des Substrats durch dielektrische Polarisation erfolgt. Außerdem ist ein mobiler Halter basierend auf einem bipolaren Träger in der WO 02111184 A1 beschrieben. Diese Halterung ist für Wafer vorgesehen.

Diese elektrostatischen Verfahren besitzen die Vorteile, eines guten flächigen Anpressdrucks, einer leichten Lösbarkeit des elektrostatischen Trägers und einer problemlosen Automatisierbarkeit. Es zeigt sich aber, dass Folien wie beispielsweise PET (PET = Poly-Ethylen-Terephtalat, Polyester) oder Polyimid zu geringe Haltekräfte gegenüber elektrostatischen Feldern aufweisen und diese Verfahren bzw. Vorrichtungen deswegen keine zuverlässige Halterung für diese Materialien liefern. Wegen der zunehmenden Bedeutung dieser Materialien ist die gegenwärtige Situation unbefriedigend.

Es ist die Aufgabe der vorliegenden Erfindung ein elektrostatisches Verfahren und eine Vorrichtung bereitzustellen, welche sich besonders für das reversible Fixieren von Substraten mit polarisierbaren Molekülen eignen und darüber hinaus eine hohe Haltekraft bei gutem flächigen Anpressdruck bieten.

Diese Aufgabe wird durch ein Verfahren gemäß Anspruch 1 und eine Vorrichtung gemäß Anspruch 6 gelöst.

Die vorliegende Erfindung schafft ein Verfahren zum Fixieren eines Substrats mit polarisierbaren Molekülen auf einem Träger mit einer ersten Flächenelektrode, wobei das Substrat zwischen der ersten Flächenelektrode und einer zweiten Flächenelektrode angeordnet wird und durch ein Anlegen einer Spannung zwischen der ersten Flächenelektrode und der zweiten Flächenelektrode eine Polarisation der polarisierbaren Moleküle bewirkt wird. Im Anschluss wird die zweite Flächenelektrode entfernt, wobei das Substrat an dem Träger fixiert bleibt, da die erste Flächenelektrode derart ausgebildet ist, dass die beim Anlegen der Spannung auf dieselbe aufgebrachten Ladungen dort verbleiben, indem die erste Flächenelektrode beim Abschalten der Spannung von der Umgebung isoliert wird, so dass die Ladungen nicht abfließen können. Dieses Verfahren eignet sich insbesondere für das Fixieren von nicht-leitenden Substraten wie beispielsweise Kunststofffolien, die keine elektrisch leitende Schicht aufweisen.

Die Spannung bzw. ein elektrisches Potential wird durch eine Spannungsquelle geliefert und eine elektrische Anziehung nach Anlegen des Potentials wird durch molekulare Dipole in dem Substrat verursacht, die entsprechend dem homogenen elektrischen Feld zwischen den beiden Flächenelektroden ausgerichtet werden. Nach kurzer Zeit (beispielsweise in Sekunden oder Minuten) kann bei einem Ausführungsbeispiel die Spannungsquelle abgeklemmt werden, und die zweite Flächenelektrode wird abgezogen. Das Abklemmen geschieht dabei derart, dass auf beiden Flächenelektroden Ladungen mit entgegengesetzter Polarität verbleiben. Das zu haftende Substrat bleibt hierbei auf dem Träger fixiert, da es weiterhin über die ausgerichteten Dipole in dem Substrat und die aufgeladenen Flächenelektrode des Trägers angezogen wird. Um die Haltekraft zu verstärken und gleichzeitig einen elektrischen Durchschlag zu verhindern, kann der Träger vorzugsweise eine Isolierschicht aufweisen.

Ein Lösen des Substrats vom Träger kann dadurch passieren, dass die beiden Flächenelektroden entladen werden, d.h. ein Ein- und Ausschalten der Haltekraft erfolgt über ein Auf- und Entladen der Flächenelektroden. Im entladenen Zustand wirkt keine elektrostatische Anziehung und das Substrat löst sich vom Träger.

Das erfindungsgemäße Konzept bietet eine ganze Reihe von Vorteilen gegenüber bekannten Verfahren und Vorrichtungen. So können beispielsweise nicht formstabile Materialien, wie beispielsweise flexible Folien, sehr einfach auf einem starren Träger fixiert werden und ebenso einfach wieder gelöst werden. Diese Trägertechnik ist temperaturstabil und die Trägerplatten sind wiederverwendbar. Es müssen keine zusätzlichen Klebeprozesse durchgeführt werden. Eine Kontamination mit Chemikalien oder Lösungsmitteln aus Klebstoffen oder Wachs wird vermieden. Auch sind keine Reinigungen nach dem Lösen des Substrats vom Träger erforderlich. Die Isolierschicht kann entsprechend den Anforderungen der gewünschten Bearbeitungsprozesse gewählt werden.

Der Träger gewährleistet einen vollflächigen und sehr ebenen Kontakt zwischen dem Substrat und einer Trägerplatte. Dies ist für Beschichtungen, Schichthärtungen und lithografischen Strukturierungen von großer Bedeutung. Es ist zu erwarten, dass sehr gleichmäßige Schichtdicken erzielt werden können und die Schichten nur wenig verspannt sind, bzw. die Schichten einen gut reproduzierbaren Schichtstress aufweisen. Dies ist mit dem bislang bekannten Stand der Technik nicht erreichbar.

Schließlich ist es ein Vorteil der vorliegenden Erfindung, dass nicht nur das Fixieren, sondern auch das Lösen der Substrate problemlos möglich ist. Das Fixieren und Lösen von Substraten kann überdies sehr schnell und automatisiert erfolgen, d.h. muss nicht von Hand ausgeführt werden.

Ein bevorzugtes Ausführungsbeispiel der vorliegenden Erfindung wird nachfolgend bezugnehmend auf die beiliegende Zeichnung näher erläutert. Es zeigt:

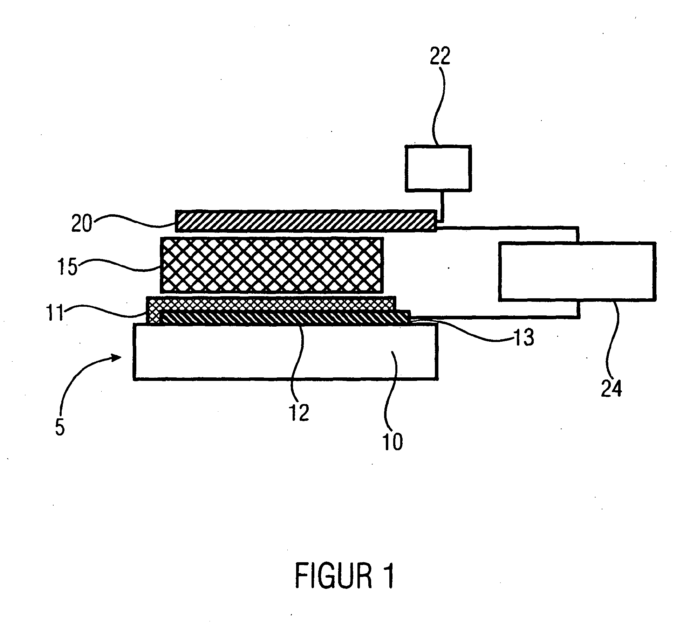

- Fig. 1: einen Querschnitt eines Trägers mit einem Substrat.

Fig. 1 zeigt einen Querschnitt eines Ausführungsbeispieles eines Trägers 5, der bei dem erfindungsgemäßen Verfahren verwendet werden kann. Der Träger 5 besteht aus einer Trägerplatte 10 mit einer Isolierschicht 11 und einer ersten Flächenelektrode 12. Die Isolierschicht 11 bedeckt die erste Flächenelektrode 12 nicht vollständig, sondern lässt eine Kontaktelektrode 13 unbedeckt. Auf diesen Träger 5 wird ein Substrat 15 gelegt und darüber eine zweite Flächenelektrode 20. Ein Auflegen und Entfernen der zweiten Flächenelektrode 20 kann automatisiert über eine schematisch dargestellte Einrichtung 22 erfolgen. Diese kann eine Herstellung eines Kontaktes des Substrats 15 mit der zweite Flächenelektrode 20 und ein Entfernen der zweiten Flächenelektrode 20 nach einem elektrostatischen Aufladeprozess der ersten Flächenelektrode 12 und der zweiten Flächenelektrode 20 mit Ladungen entgegengesetzter Polarität bewirken.

Die Aufladung wird durch eine Einrichtung zum Anlegen einer Spannung 24 bewirkt und die Aufladespannung kann beispielsweise im Bereich zwischen 200 Volt und 3000 Volt liegen. Bei einem bevorzugten Ausführungsbeispiel liegt die Spannung nur solange an der ersten Flächenelektrode 12 und der zweiten Flächenelektrode 20 an bis eine Fixierung des Substrats 15 am Träger 5 hergestellt ist. Danach wird die Spannung derart abgeklemmt, dass auf der ersten Flächenelektrode 12 Ladungen verbleiben, durch die das Substrat 15 über die ausgebildeten Dipole desselben fixiert bleibt. Die zweite Flächenelektrode 20, die auch als Gegenelektrode bezeichnet werden kann, wird dann entfernt, so dass es möglich ist, das Substrat 15 von der dem Träger 5 gegenüberliegenden Seite her zu bearbeiten. Ausführungsbeispiele der vorliegenden Erfindung umfassen ferner einen oder mehrere Schritte des Bearbeitens des Substrats 15 im an dem Träger 5 fixierten Zustand. Solche Schritte können beispielsweise ein Beschichten, Lithographie, Trocknungs- und Heizprozesse, Strukturierungsprozesse, Dünnen, Schleifen und dergleichen sein.

Bei einem weiteren Ausführungsbeispiel kann die Einrichtung zum Anlegen einer Spannung 24 zwischen der ersten Flächenelektrode 12 und der zweiten Flächenelektrode 20 permanent ein Potential aufrechterhalten.

Nachdem die zweite Flächenelektrode 20 entfernt wurde und das Substrat 15 aufgrund der elektrostatischen Anziehung auf dem Träger 5 fixiert ist, kann, wie ausgeführt wurde, das Substrat 15 in weiteren Schritten bearbeitet bzw. behandelt werden. Die Verbindung zwischen dem Substrat 15 und dem Träger 5 kann durch erneutes Anlegen der zweiten Flächenelektrode 20 und einer anschließenden Entladung der ersten Flächenelektrode 12 und der zweiten Flächenelektrode 20 gelöst werden. Die Entladung bewirkt ein Verschwinden der elektrostatischen Anziehung und folglich auch ein Aufheben der Fixierung des Substrats 15 am Träger 5.

Die zweite Flächenelektrode 20 kann als flexible Folienelektrode oder als starrer Körper ausgeführt werden. In jedem Fall sollte das Entfernen der zweiten Flächenelektrode 20 auf eine solche Weise erfolgen, dass das Substrat 15 an dem Träger 5 fixiert bleibt und nicht an der zweiten Flächenelektrode 20 haftet. Dies kann erreicht werden, wenn das Entfernen so erfolgt, dass keine ganzflächige Kraft auf das Substrat 15 wirkt, sondern lediglich eine punkt- oder linienförmige Krafteinwirkung stattfindet. Im Falle einer flexiblen zweiten Flächenelektrode 20 kann dies durch ein Abschälen erfolgen und im Falle einer starren zweiten Flächenelektrode 20 durch ein Abkippen. Ein Abkippen bzw. ein Abschälen erzeugt eine hohe Abzugskraft entlang einer Linie und nicht entlang einer Fläche, wie beim senkrechten Abheben. Somit kann sichergestellt werden, dass beim Abheben der zweiten Flächenelektrode 20 das Substrat 15 nicht an der zweiten Flächenelektrode 20 haften bleibt. Für eine erfindungsgemäße Funktionsweise ist es also wichtig, sicherzustellen, dass die Abzugskraft im wesentlichen nur auf die Flächenelektrode 20 und nicht auf das Substrat 15 wirkt.

Bei einem anderen Ausführungsbeispiel kann allerdings ein Haften des Substrats 15 an der zweiten Flächenelektrode 20 für einen weiteren Schritt des Verfahrens von Vorteil sein. Das ist zum Beispiel der Fall, wenn nach dem Bearbeiten des Substrates 15 ein Entfernen des Substrats 15 vom Träger 5 erfolgen soll. Dazu kann eine elektrostatische Anziehung zwischen zweiter Flächenelektrode 20 und Substrat 15 bewirkt werden, indem eine entsprechende Spannung zwischen der ersten Flächenelektrode 12 und zweiten Flächenelektrode 20 angelegt wird, woraufhin die Ladungen auf der zweiten Flächenelektrode 20 und nicht der ersten Flächenelektrode 12 belassen werden. Somit kann die zweite Flächenelektrode 20 mitsamt des Substrats 15 von dem Träger 5 entfernt werden.

Bei einem weiteren Ausführungsbeispiel kann die zweite Flächenelektrode 20 auch als eine Folien-Flächenelektrode ausgeführt werden. Bei diesem Ausführungsbeispiel ist die zweite Flächenelektrode 20 flexibel, was den Abschälvorgang erleichtert, so dass eine solche Ausführung bevorzugt sein kann. Beispielsweise kann die zweite Flächenelektrode 20 eine Metallfolie oder eine Folie mit leitender Beschichtung sein.

Grundsätzlich kann die Fläche der ersten Flächenelektrode 12 und/oder der zweiten Flächenelektrode 20 größer oder kleiner sein als das Substrat 15. Es kann aber vorteilhaft sein, z.B. um elektrische Durchbrüche zu vermeiden, dass die Fläche der zweiten Flächenelektrode 20 etwas kleiner ist als das aufgelegte Substrat 15. Die erste Flächenelektrode 12 ist vorteilhafterweise etwas größer als die Fläche des Substrats 15.

Bei weiteren Ausführungsbeispielen kann die erste Flächenelektrode 12 und die zweite Flächenelektrode 20 eine andere Form haben, d.h. das Substrat 15 muss nicht ganzflächig bedeckt sein. Ebenso wenig braucht die Isolierschicht 11 Bestandteil des Trägers 5 zu sein. Die Isolierschicht 11 kann beispielsweise ein Bestandteil des Substrats 15 sein bzw. für Substrate 15 aus bestimmten Materialien bzw. mit einer bestimmten Dicke kann ganz auf die Isolierschicht 11 verzichtet werden. Dies ist immer dann möglich, wenn ein elektrischer Durchschlag bzw. ein sicheres Fixieren auch ohne Isolierschicht 11 sichergestellt werden kann. Schließlich braucht die Isolierschicht 11 nicht fest mit dem Träger 5 verbunden zu sein, sondern kann stattdessen lose auf dem Träger 5 oder auf das Substrat 15 gelegt werden.

Bei weiteren Ausführungsbeispielen kann das Substrat 15 neben Kunststofffolien und dünnen Halbleitern auch dünne, biegsame Glas- oder Keramiksubstrate aufweisen. Außerdem kann bei weiteren Ausführungsbeispielen der Vorgang des elektrostatischen Fixierens (Anlegen einer Spannung zwischen den Elektroden) auch unter Vakuumbedingungen erfolgen, zum Beispiel innerhalb einer Vakuumkammer durchgeführt werden. Das kann zum Beispiel dahingehend vorteilhaft sein, dass sich dadurch Luftblasen, die andererseits zwischen Substrat 15 (Folie) und Träger 5 eingeschlossen sein könnten, vermeiden lassen. Bei einer Kontaktierung unter Luft (außerhalb einer Vakuumkammer bzw. unter normalen Luftdruckbedingungen) sind solche Blasen nicht auszuschließen und können zu Aufwölbungen führen, was für spätere Prozesse (z.B. Sputtern, Plasmaätzen) unter Vakuumbedingungen nachteilig ist.

Außerdem kann bei weiteren Ausführungsbeispielen eine reversible Verfugung des Randbereiches zwischen Folie und Träger 5 vorgenommen werden, was vorteilhaft insbesondere hinsichtlich von Beckenprozessen sein kann. Beispielsweise kann eine Polyimidfolie elektrostatisch fixiert und mit Polyimid beschleudert werden. Anschließend kann die schicht beispielsweise bei 300 bis 400 °C gebacken werden, so dass der Folienrand verfugt wäre. Daran anschließend könnte der Träger 5 auch in Beckenprozesse (Reinigung, Fototechnik, etc.) eingesetzt werden.

## Patentansprüche

1. Verfahren zum Handhaben eines elektrisch isolierenden Festkörper-Substrats (15), das polarisierbare Moleküle aufweist, mit folgenden Schritten:
Bereitstellen eines Trägers (5), der eine erste Flächenelektrode (12) aufweist;
Anordnen des elektrisch isolierenden Festkörper-Substrats (15) zwischen der ersten Flächenelektrode (12) und einer zweiten Flächenelektrode (20), und Anlegen einer Spannung zwischen der ersten Flächenelektrode (12) und der zweiten Flächenelektrode (20), so dass die polarisierbaren Moleküle polarisiert werden und **dadurch** das elektrisch isolierenden Festkörper-Substrat (15) an dem Träger (5) fixiert wird; und
Entfernen der zweiten Flächenelektrode (20), wobei das Substrat (15) an dem Träger (5) fixiert bleibt.

2. Verfahren gemäß Anspruch 1, bei dem zwischen dem Substrat (15) und der ersten Flächenelektrode (12) und/oder zweiten Flächenelektrode (20) eine Isolierschicht (11) angeordnet wird.

3. Verfahren gemäß einem der Ansprüche 1 oder 2, bei dem die zweite Flächenelektrode (20) derart entfernt wird, dass eine dabei wirkende Abzugskraft entlang einer Linie wirkt.

4. Verfahren gemäß Anspruch 3, bei dem die zweite Flächenelektrode (20) flexibel ist und zum Entfernen von dem elektrisch isolierenden Festkörper-Substrat (15) abgeschält wird.

5. Verfahren gemäß einem der Ansprüche 1 bis 3, bei dem die zweite Flächenelektrode (20) starr ist und zum Entfernen von dem elektrisch isolierenden Festkörper-Substrat (15) gekippt wird.

6. Verfahren gemäß einem der Ansprüche 1 bis 5, bei dem der Schritt des Anlegens einer Spannung in einem Vakuum erfolgt.

7. Vorrichtung zum Handhaben eines Substrats (15), das polarisierbare Moleküle aufweist, mit folgenden Merkmalen:
einem Träger (5) mit einer ersten Flächenelektrode (12);
einer zweiten Flächenelektrode (20), wobei die erste Flächenelektrode (12) und zweite Flächenelektrode (20) derart ausgebildet sind, dass das Substrat (15) zwischen denselben platzierbar und die zweite Flächenelektrode (20) als eine Folienelektrode ausgebildet ist; und
einer Einrichtung zum Anlegen einer solchen Spannung (24) zwischen der ersten Flächenelektrode (12) und der zweiten Flächenelektrode (20), dass **dadurch** die polarisierbaren Moleküle polarisierbar sind und **dadurch** das Substrat (15) an dem Träger (5) fixierbar ist; und
einer Einrichtung zum Entfernen (22) der zweiten Flächenelektrode (20).

8. Vorrichtung gemäß Anspruch 7, die ferner eine Isolierschicht (11), die zwischen dem Substrat (15) und der ersten Flächenelektrode (12) und/oder dem Substrat und der zweiten Flächenelektrode (20) angeordnet ist, aufweist.

9. Vorrichtung gemäß einem der Ansprüche 7 oder 8, bei der die Einrichtung zum Entfernen (22) derart ausgebildet ist, dass die zweite Flächenelektrode (20) derart entfernbar ist, dass eine dabei wirkende Abzugskraft entlang einer Linie wirkt.

10. Vorrichtung gemäß einem der Ansprüche 7 bis 9, bei dem die erste Flächenelektrode (12) flächenmäßig größer ist als die zweite Flächenelektrode (20).

11. Vorrichtung gemäß einem der Ansprüche 7 bis 10, bei dem der Träger (5) in einer Vakuumkammer angeordnet ist.

## Claims

1. Method for handling an electrically insulating solid substrate (15) having polarizable molecules, comprising:
providing a carrier (5) comprising a first junction electrode (12);
disposing the electrically insulating solid substrate (15) between the first junction electrode (12) and a second junction electrode (20), and applying a voltage between the first junction electrode (12) and the second junction electrode (20), so that the polarizable molecules are polarized and the electrically insulating solid substrate (15) is thereby fixed on the carrier (5); and
removing the second junction electrode (20), wherein the substrate (15) remains fixed on the carrier (5).

2. Method according to claim 1, wherein an insulation layer (11) is disposed between the substrate (15) and the first junction electrode (12) and/or the second junction electrode (20).

3. Method according to one of claims 1 or 2, wherein the second junction electrode (20) is removed such that a stripping force then acting acts along a line.

4. Method according to claim 3, wherein the second junction electrode (20) is flexible and is peeled off for being removed from the electrically insulating solid substrate (15).

5. Method according to one of claims 1 to 3, wherein the second junction electrode (20) is rigid and is tilted for being removed from the electrically insulating solid substrate (15).

6. Method according to one of claims 1 to 5, wherein the step of applying a voltage is made in a vacuum.

7. Device for handling a substrate (15) having polarizable molecules, comprising:
a carrier (5) with a first junction electrode (12);
a second junction electrode (20), wherein the first junction electrode (12) and the second junction electrode (20) are formed such that the substrate (15) may be placed therebetween and the second junction electrode (20) is formed as a foil electrode; and
a means for applying such a voltage (24) between the first junction electrode (12) and the second junction electrode (20) that the polarizable molecules are thereby polarizable and the substrate (15) is thereby fixed on the carrier (5); and
a means for removing (22) the second junction electrode (20).

8. Device according to claim 7, further comprising an insulation layer (11) disposed between the substrate (15) and the first junction electrode (12) and/or the substrate and the second junction electrode (20).

9. Device according to one of claims 7 or 8, wherein the means for removing (22) is formed such that the second junction electrode (20) is removable such that a stripping force then acting acts along a line.

10. Device according to one of claims 7 to 9, wherein the first junction electrode (12) has a larger area than the second junction electrode (20).

11. Device according to one of claims 7 to 10, wherein the carrier (5) is disposed in a vacuum chamber.

## Revendications

1. Procédé de manipulation d'un substrat de corps solide isolant électrique (15) présentant des molécules polarisables, aux étapes suivantes consistant à:
préparer un support (5) présentant une première électrode de surface (12);
disposer le substrat de corps solide isolant électrique (15) entre la première électrode de surface (12) et une deuxième électrode de surface (20), et appliquer une tension entre la première électrode de surface (12) et la deuxième électrode de surface (20), de sorte que les molécules polarisables soient polarisées et que le substrat de corps solide isolant électrique (15) soit fixé au support (5); et
enlever la deuxième électrode de surface (20), le substrat (15) restant fixé au support (5).

2. Procédé selon la revendication 1, dans lequel une couche isolante (11) est disposée entre le substrat (15) et la première électrode de surface (12) et/ou la deuxième électrode de surface (20).

3. Procédé selon l'une des revendications 1 ou 2, dans lequel la deuxième électrode de surface (20) est enlevée de sorte qu'une force d'enlèvement agisse le long d'une ligne.

4. Procédé selon la revendication 3, dans lequel la deuxième électrode de surface (20) est flexible et est écaillée pour l'enlèvement du substrat de corps solide isolant électrique (15).

5. Procédé selon l'une des revendications 1 à 3, dans lequel la deuxième électrode de surface (20) est rigide et est basculée pour l'enlèvement du substrat de corps solide isolant électrique (15).

6. Procédé selon l'une des revendications 1 à 5, dans lequel l'étape d'application d'une tension a lieu sous vide.

7. Dispositif de manipulation d'un substrat (15) présentant des molécules polarisables, aux caractéristiques suivantes:
un support (5) avec une première électrode de surface (12);
une deuxième électrode de surface (20), la première électrode de surface (12) et la deuxième électrode de surface (20) étant réalisées de sorte que le substrat (15) puisse être placé entre ces dernières et la deuxième électrode de surface (20) étant réalisée sous forme d'électrode en film; et
un moyen pour appliquer une tension (24) entre la première électrode de surface (12) et la deuxième électrode de surface (20) telle que les molécules polarisables puissent être polarisées et que le substrat (15) puisse être fixé au support (5); et
un moyen pour enlever (22) la deuxième électrode de surface (20).

8. Dispositif selon la revendication 7, présentant par ailleurs une couche isolante (11) disposée entre le substrat (15) et la première électrode de surface (12) et/ou le substrat et la deuxième électrode de surface (20).

9. Dispositif selon l'une des revendications 7 ou 8, dans lequel le moyen pour enlever (22) est réalisé de sorte que la deuxième électrode de surface (20) puisse être enlevée de sorte qu'une force d'enlèvement agisse le long d'une ligne.

10. Dispositif selon l'une des revendications 7 à 9, dans lequel la première électrode de surface (12) est de surface plus grande que la deuxième électrode de surface (20).

11. Dispositif selon l'une des revendications 7 à 10, dans lequel le support (5) est disposé dans une chambre à vide.
